# EUROPÄISCHE PATENTSCHRIFT

(11) **EP 2 873 102 B1**
(45) Veröffentlichungstag und Bekanntmachung des Hinweises auf die Patenterteilung: **15.06.2016**
(21) Anmeldenummer: 13736846.0
(22) Anmeldetag: 03.07.2013
(51) Int. Cl.: H01L 41/23, H01L 41/053, F02M 51/06, F02M 69/04

(54) **VERFAHREN ZUM HERSTELLEN EINES FESTKÖRPERAKTUATORS**
METHOD OF MANUFACTURING A SOLID STATE ACTUATOR
PROCÉDÉ DE FABRICATION D'UN ACTIONNEUR À CORPS SOLIDE

(30) Priorität: 13.07.2012 DE 102012212264
(43) Veröffentlichungstag der Anmeldung: 20.05.2015
(73) Patentinhaber: Continental Automotive GmbH, 30165 Hannover (DE)
(72) Erfinder: SCHÜRZ, Willibald, 93188 Pielenhofen (DE)
(86) Internationale Anmeldenummer: PCT/EP2013/064074
(87) Internationale Veröffentlichungsnummer: WO 2014/009228

(56) Entgegenhaltungen:
- DE-A1-102007 016 626

## Beschreibung

Die Erfindung betrifft ein Verfahren zum Herstellen eines Festkörperaktuators, der insbesondere in einem Fluidinjektor eingesetzt wird und der beispielsweise ein piezoelektrischer Aktuator sein kann. Derartige Fluidinjektoren werden beispielsweise bei Brennkraftmaschinen eingesetzt zum Zumessen von Kraftstoff. Im Hinblick auf hohe Anforderungen an Brennkraftmaschinen, die in Kraftfahrzeugen angeordnet sind, wie beispielsweise hinsichtlich einer sehr gezielten Leistungseinstellung und/oder der Erfüllung strenger Schadstoffemissionsvorschriften, ist ein präzises Zumessen des Fluids mittels des jeweiligen Fluidinjektors wichtig.

In diesem Zusammenhang werden, insbesondere auch bei Diesel-Brennkraftmaschinen, Fluidinjektoren mit Festkörperaktuatoren eingesetzt. Das zuzumessende Fluid wird beispielsweise im Falle von Diesel häufig mit einem Speisedruck von bis zu zirka 2500 bar dem Fluidinjektor zugeführt und dann mittels des Fluidinjektors in den jeweiligen Brennraum der Brennkraftmaschine zugemessen.

Der Festkörperaktuator umfasst eine Aktuatorbaueinheit, diesbezüglich ist es hinsichtlich eines hohen Wirkungsgrads wichtig, die Aktuatorbaueinheit mit einer von ihrem Querschnitt abhängigen Kraft vorzuspannen. Durch das Vorsehen einer vorgegebenen Vorspannkraft kann auch eine ausreichende Dauerlauffähigkeit erzielt werden.

Darüber hinaus wird die Aktuatorbaueinheit in dem Fluidinjektor regelmäßig vor dem Kontakt mit Kraftstoff geschützt, um Beschädigungen an einer Isolierung oder einer elektrischen Kontaktierung zu vermeiden.
In diesem Zusammenhang ist es beispielsweise bei einer Aktuatorbaueinheit, die als Piezostack ausgebildet ist, bekannt, die Vorspannung mittels einer Rohrfeder vorzugeben. Abdichten erfolgt mit einer Membran, welche an einem Injektorkörper und an einer Bodenplatte der Aktuatorbaueinheit eingeschweißt ist.

Es wird zudem auf das Dokument DE102007016626 Bezug genommen.

Die Aufgabe, die der Erfindung zugrunde liegt, ist es, ein Verfahren zum Herstellen eines Festkörperaktuators zu schaffen, mittels dessen ein Festkörperaktuator hergestellt wird, der auch bei sehr begrenzt zur Verfügung stehenden Bauraum einen Beitrag für einen zuverlässigen Betrieb leistet.
Die Aufgabe wird gelöst durch die Merkmale des unabhängigen Patentanspruchs. Vorteilhafte Ausgestaltungen sind in den Unteransprüchen gekennzeichnet.
Gemäß einer Ausführungsform zeichnet sich die Erfindung aus durch ein Verfahren zum Herstellen eines Festkörperaktuators mit einer Aktuatorbaueinheit, einer Kopfplatte und einer Bodenplatte. Es wird ein Hohlzylinderteil aus Maraging-Stahl bereitgestellt. Der Begriff Maraging ist eine Zusammenfassung der englischen Worte Martensit und Aging und wird regelmäßig verwendet für Martensit aushärtbarem Stahl.
Das Hohlzylinderteil ist somit rohrförmig ausgebildet und zwar insbesondere rohrstückförmig.
Das Hohlzylinderteil wird auf eine vorgegebene erste Temperatur erwärmt, bei der der Maraging-Stahl in einem austenitischen Zustand ist. Mittels eines Umformprozesses wird ein Wellrohr aus dem Hohlzylinderteil geformt und zwar während der Maraging-Stahl in einem austenitischen Zustand ist. Das Wellrohr wird anschließend abgekühlt und zwar derart, dass der Maraging-Stahl in einem martensitischen Zustand ist.

Die Aktuatorbaueinheit wird in das Wellrohr eingebracht. Die Kopfplatte und die Bodenplatte werden derart an dem Wellrohr fixiert, dass die Aktuatorbaueinheit mit einer vorgegebenen Vorspannung zwischen der Kopfplatte und der Bodenplatte eingespannt ist. Dabei ist die Vorspannung vorgegeben bei einer vorgegebenen Temperatur, so beispielsweise Raumtemperatur, und einem vorgegebenen Zustand der Aktuatorbaueinheit, insbesondere einem Ladungszustand, der einem neutralen Zustand entsprechen kann.

Auf diese Weise kann insbesondere auch bei großen Aktorhüben eine hohe Zuverlässigkeit gewährleistet werden und insbesondere eine hohe Lebensdauerfestigkeit gewährleistet werden. Im Gegensatz zu einer Lösung, bei der eine Abdichtung in einem Fluidinjektor mittels einer Membran erfolgt, die an der Bodenplatte und einem Injektorkörpers des Fluidinjektors angeschweißt ist, wird die Problematik des Überschreitens einer Belastbarkeitsgrenze dieser Membran vermieden. Dies ist insbesondere vorteilhaft beim Einsatz des Festkörperaktuators in einem Fluidinjektor, bei welchem ein hydraulischer Spielausgleich vorgesehen ist und thermische Längenänderungsunterschiede zwischen dem Festkörperaktuator und dem Injektorkörper als quasi statischer Hub und somit als Belastung für das die Dichtfunktion bezüglich des Fluids übernehmende Bauteil auftreten.

Durch das Vorsehen der Aktuatorbaueinheit in dem Wellrohr und das Fixieren der Kopfplatte und der Bodenplatte an dem Wellrohr, wobei die Aktuatorbaueinheit mit der vorgegebenen Vorspannung zwischen der Kopfplatte und der Bodenplatte eingespannt ist, kann insbesondere im Zusammenhang mit einer Fixierung, die die Bodenplatte und/oder die Kopfplatte dichtend an dem Wellrohr fixiert, sichergestellt werden, dass die Aktuatorbaueinheit hermetisch dicht von dem Fluid, das insbesondere Kraftstoff ist, getrennt ist.

Darüber hinaus kann durch das Vorgehen das Wellrohr so ausgeformt werden, dass es eine benötigte Federkonstante erreicht, ohne zulässige Spannungen zum Erreichen einer Lebensdauerfestigkeit zu überschreiten. Als Designparameter bezüglich des Wellrohrs stehen hierfür insbesondere eine Wandstärke, eine Wellenperiode und eine Amplitude des Wellrohres zur Verfügung.

Durch das Vorsehen des Maraging-Stahls im Zusammenhang mit den oben genannten Schritten beim Herstellen des Festkörperaktuators kann bei dem Umformprozess besonders günstig eine plastische Verformung erfolgen und zwar von der Form des Hohlzylinderteils zu dem Wellrohr.

Durch das anschließende Abkühlen des Wellrohrs, derart, dass der Maraging-Stahl in dem martensitischen Zustand ist, und zwar insbesondere größtenteils in dem martensitischen Zustand ist, kann eine sehr hohe Festigkeit erreicht werden. Darüber hinaus kann durch dieses Vorgehen auch bei einem begrenzt zur Verfügung stehenden Bauraum das Wellrohr mit den benötigten Eigenschaften hergestellt werden.

Gemäß einer vorteilhaften Ausgestaltung liegt die erste Temperatur in einem Bereich zwischen 700 bis 950 °C. In diesem Temperaturbereich bei der ersten Temperatur in dem genannten Bereich ist der Maraging-Stahl in den austenitischen Zustand übergeführt. In diesem Zustand ist das plastische Verformungsvermögen sehr hoch, beispielsweise größer als 30 %.

Gemäß einer weiteren vorteilhaften Ausgestaltung wird nach dem Umformprozess das Wellrohr zunächst abgekühlt, bis eine vorgegebene Bedingung erfüllt ist. Die vorgegebene Bedingung kann beispielsweise erfüllt sein, wenn eine vorgegebene zweite Temperatur in etwa erreicht wird, die beispielsweise in etwa einer Raumtemperatur entsprechen kann. Anschließend wird das Wellrohr wieder erwärmt und in einem vorgegebenen Temperaturbereich für eine vorgegebene Zeitdauer gealtert. Die Zeitdauer kann beispielsweise in einem Bereich von zwei bis vier Stunden liegen. Besonders vorteilhaft liegt der vorgegebene Temperaturbereich zum Altern zwischen 400 und 500 °C, insbesondere zwischen 450 und 480 °C. Nach dem erstmaligen Abkühlen auf die zweite Temperatur, die insbesondere in etwa der Raumtemperatur entspricht, klappt das Gitter des Maraging-Stahls größenteils in den martensitischen Zustand um. Durch das Altern, das auch als Auslagern bezeichnet wird, wird die Martensitbildung vervollständigt und es kann eine besonders hohe Festigkeit erreicht werden, die beispielsweise Werte ≥ 2000 MPa aufweisen kann.

Gemäß einer weiteren vorteilhaften Ausgestaltung umfasst der Umformprozess das Einbringen des Hohlzylinderteils in ein Formteil und ein Beaufschlagen des Hohlzylinderteils in seinem freien Innenraum mit einem vorgegebenen Gasdruck. Der Gasdruck liegt in einem Bereich von etwa 700 bar. Das Gas wird in diesem Zusammenhang bevorzugt Stickstoff eingesetzt.

Ausführungsbeispiele der Erfindung sind im Folgenden anhand der schematischen Zeichnungen näher erläutert. Es zeigen:

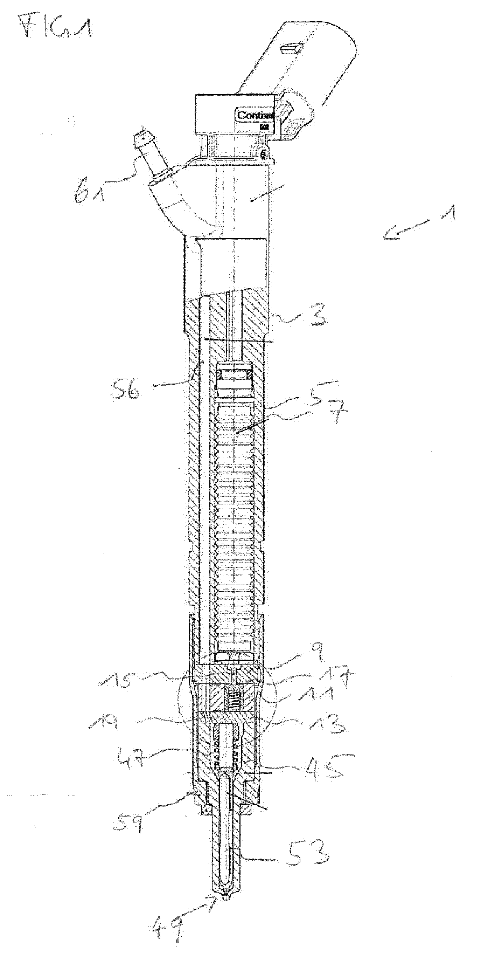

- Figur 1: einen teilweisen Querschnitt durch einen Fluidinjektor mit einem Festkörperaktuator,
- Figur 2: ein Wellrohr,
- Figur 3: einen vergrößerten Ausschnitt aus dem Wellrohr gemäß Figur 2,
- Figur 4: den Festkörperaktuator und
- Figur 5: ein Ablaufdiagramm im Zusammenhang mit einem Herstellen des Festkörperaktuators.

Elemente gleicher Konstruktion oder Funktion sind figurenübergreifend mit den gleichen Bezugszeichen gekennzeichnet.

Ein Fluidinjektor 1 weist einen Injektorkörper auf, der grundsätzlich einstückig, aber bevorzugt mehrstückig ausgebildet ist. So umfasst der Injektorkörper in einer mehrstückigen Ausbildung ein Injektorkörperteil 3, eine Zwischenplatte 9, eine Steuerplatte 11 und eine Endplatte 13.

Das Injektorkörperteil 3 hat eine Aktuatorausnehmung 5, in die ein Festkörperaktuator 7 eingebracht ist. Der Festkörperaktuator 7 ist beispielsweise ausgebildet als piezoelektrischer Aktuator und ist ein elektromagnetischer Wandler.

Der Injektorkörper, insbesondere das Injektorkörperteil 3, muss gegebenenfalls nicht notwendigerweise eine Temperaturausgleichsfunktion erfüllen und kann so aus einem Werkstoff gefertigt werden, welcher hinsichtlich Hochdruckfestigkeit optimiert sein kann.

Insbesondere in der Steuerplatte 11 ist eine Steuerkolbeneinheitsausnehmung ausgebildet, in der eine Steuerkolbeneinheit angeordnet ist.

Ferner ist eine Übertragungsstiftausnehmung in der Zwischenplatte vorgesehen, die diese insbesondere axial durchdringt und zwar hin zu der Steuerkolbeneinheitsausnehmung. In der Übertragungsstiftausnehmung ist ein Übertragungsstift 15 derart angeordnet, dass er die Übertragungsstiftausnehmung durchdringt und den Festkörperaktuator 7 mit der Steuerkolbeneinheit mechanisch koppelt.

Durch die Steuerkolbeneinheit wird ein erster Steuerraum 17 begrenzt. Der erste Steuerraum 17 ist hydraulisch gekoppelt mit einem zweiten Steuerraum 19 und zwar über eine Verbindungsbohrung.

Ferner ist ein Düsenkörper 45 vorgesehen, der eine Düsenkörperausnehmung 47 aufweist. Von der Düsenkörperausnehmung 47 sind eine oder mehrere Einspritzlöcher in einem Bereich 49 einer Düsenspitze ausgebildet und zwar den Düsenkörper 45 ausgehend von der Düsenkörperausnehmung 47 durchdringend nach außen. In der Düsenkörperausnehmung 47 ist eine Düsennadel 53 angeordnet, die mit einer der Düsenspitze abgewandten Stirnfläche den zweiten Steuerraum 19 begrenzt. Die Düsennadel 53 ist axial beweglich in der Düsenkörperausnehmung 47 angeordnet und zwar derart, dass sie in einer Schließposition einen Fluidfluss durch das eine oder die mehreren Einspritzlöcher unterbindet und ihn andernfalls freigibt. Darüber hinaus ist eine Speisebohrung 56 in dem Injektorkörperteil 3 und weiter in der Zwischenplatte 9, der Steuerplatte 11 und der Endplatte 13 vorgesehen, die hydraulisch gekoppelt ist mit einem Fluidanschluss 61, der mit einer Fluidzuführung während des Betriebs hydraulisch gekoppelt ist, mittels der während des Betriebs des Fluidinjektors 1 diesem das zuzumessende Fluid unter dem Speisedruck zugeführt wird.

Der Düsenkörper 45 ist über eine Düsenspannmutter 59 mit dem Injektorkörper gekoppelt. Die Düsenspannmutter 59 kann beispielsweise mittels einer Schweißverbindung an den Injektorkörper, insbesondere an dem Injektorkörperteil 3 fest befestigt sein.

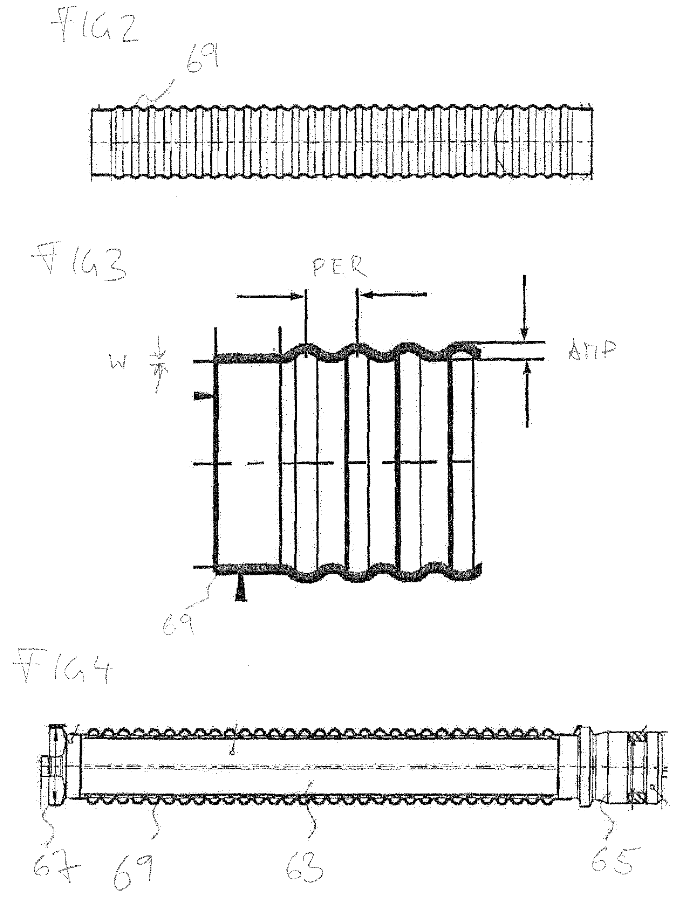

Der Festkörperaktuator 7 umfasst ein Wellrohr 69 (Figur 2). Das Wellrohr 69 ist aus einem Maraging-Stahl hergestellt. Maraging-Stähle sind hochfest und weisen eine hohe Festigkeit und eine gute Zähigkeit auf. Sie umfassen im Wesentlichen kohlenstofffreie Legierungen und sind mit einem hohen Anteil von Nickel, so beispielsweise größer als 12%, legiert. Sie enthalten auch gegebenenfalls weitere Legierungselemente, wie beispielsweise Aluminium, Molybdän, Kupfer, Niob, Kobalt und/oder Titan.
Designparameter des Wellrohrs 69 sind neben dem Material eine Wandstärke W, eine Wellenperiode PER und eine Wellenamplitude AMP. Bei einem Außendurchmesser von beispielsweise 9,2 mm kann die Wanddicke beispielsweise in etwa 0,2 mm betragen, die Wellenamplitude AMP in etwa 0, 4 mm betragen und die Wellenperiode in etwa 2 mm betragen. So kann eine Federkonstante von beispielsweise 1,8 N/µm bei einer Vorspannkraft von in etwa 800 N bei dem fertig hergestelltem Festkörperaktuator 7 erreicht werden bei einer vorgegebenen Temperatur und einem vorgegebenen Zustand der Aktuatorbaueinheit, insbesondere Ladungszustand. Dabei handelt es sich insbesondere um einen Neutralzustand, bei dem die Aktuatorbaueinheit im Wesentlichen entladen ist.

Das Wellrohr hat beispielsweise eine Länge von 63 mm.

Die Aktuatorbaueinheit ist bevorzugt ein Piezoaktor, insbesondere ein Piezostapel.

Der Festkörperaktuator umfasst neben der Aktuatorbaueinheit 63 das Wellrohr 69, eine Kopfplatte 65 und eine Bodenplatte 67.

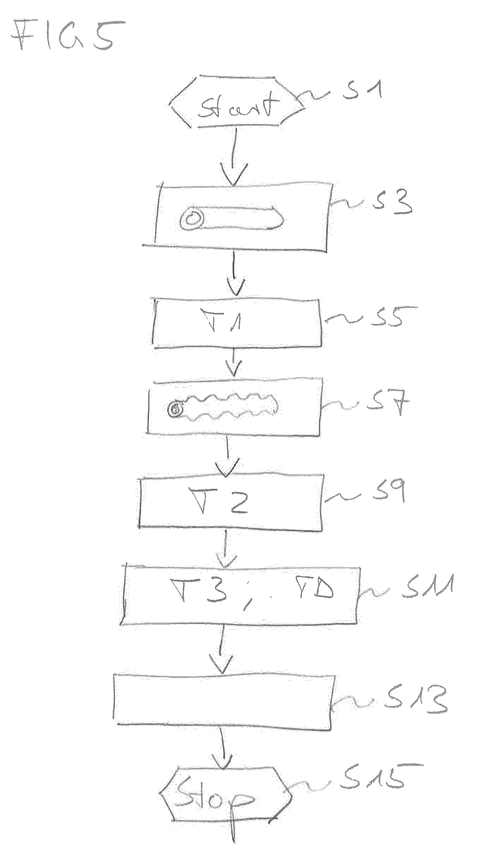

Ein Herstellen des Festkörperaktuators 7 ist im Folgenden anhand des Ablaufdiagramms der Figur 5 beschrieben. In einem Schritt S1 erfolgt ein Start. In einem Schritt S3 wird ein Hohlzylinderteil aus Maraging-Stahl bereitgestellt.

In einem Schritt S5 wird das Hohlzylinderteil auf eine vorgegebene erste Temperatur T1 erwärmt, bei der der Maraging-Stahl in einem austenitischen Zustand ist. Die erste Temperatur liegt bevorzugt in einem Bereich zwischen 700 und 950 °C, so insbesondere beispielsweise bei 850 °C.
In einem Schritt S7 wird mittels eines Umformprozesses ein Wellrohr 69 aus dem Hohlzylinderteil geformt und zwar während der Maraging-Stahl in dem austenitischen Zustand ist. Zu diesem Zweck wird das Hohlzylinderteil in ein Formteil eingebracht, das an seiner radial innen liegenden Kontur der Außenkontur des Wellrohrs 69 entspricht. Das Hohlzylinderteil wird dann in seinem freien Innenraum mit einem vorgegebenen Gasdruck beaufschlagt, der beispielsweise in einem Bereich von 600 bis 800 bar, insbesondere bei in etwa 700 bar liegt, und wird bevorzugt mit Stickstoff beaufschlagt. Auf diese Weise wird die Außenkontur an die Innenkontur des Formteils angepasst und somit das Wellrohr 69 gebildet.

In diesem Zusammenhang ist festzustellen, dass bei geeignet hohen Temperaturen eine besonders gute Verformbarkeit des dann im austenitischen Zustand befindlichen Maraging-Stahls möglich ist. Bei niedrigeren Temperaturen, bei denen weiterhin der austenitische Zustand vorhanden ist, was in der Regel bei Temperaturen von in etwa über 200 °C der Fall ist, ist es grundsätzlich möglich, das Hohlzylinderteil zu dem Wellrohr umzuformen. Allerdings ist ein Umformen in dem oben angegebenen Temperaturbereich besonders vorteilhaft möglich.

In einem Schritt S9 erfolgt ein Abkühlen des Wellrohrs 69 bis eine vorgegebene Bedingung erfüllt ist. Die vorgegebene Bedingung ist beispielsweise derart vorgegeben, dass in etwa eine Raumtemperatur erreicht ist, so zum Beispiel in etwa 20 °C.

Anschließend wird in einem Schritt S11 eine Alterung des Maraging-Stahls durchgeführt und zwar durch ein erneutes Aufwärmen des Wellrohres 69 auf eine vorgegebene dritte Temperatur T3, die in einem Temperaturbereich von beispielsweise zwischen 400 °C und 500 °C liegt, insbesondere zwischen 450 °C und 480 °C. In diesem Temperaturbereich wird dann das Wellrohr 69 diesen Temperaturen für eine vorgegebene Zeitdauer TD von beispielsweise zwei bis vier Stunden ausgesetzt. Dieses Vorgehen wird auch als Auslagern bezeichnet und führt zu einer Vervollständigung der Martensitbildung. Es können so sehr hohe Festigkeitswerte erreicht werden, die beispielsweise einen Wert von größer oder gleich 2000 MPa aufweisen können.

In einem Schritt S13 wird die Aktuatorbaueinheit 63 in das Wellrohr 69 eingebracht. Ferner werden die Kopfplatte 65 und die Bodenplatte 67 derart in dem Wellrohr 69 fixiert, dass die Aktuatorbaueinheit 63 mit einer vorgegebenen Vorspannung zwischen der Kopfplatte 65 und der Bodenplatte 67 eingespannt ist. Die Vorspannung ist gegeben bei einer vorgegebenen Temperatur, die beispielsweise in etwa der Raumtemperatur entspricht, und bei vorgegebenem Zustand der Aktuatorbaueinheit 63, der insbesondere dem Neutralzustand entspricht. Die Vorspannung beträgt beispielsweise in etwa 800 N.

Das Fixieren der Kopfplatte 65 und der Bodenplatte 67 kann beispielsweise mittels Schweißens, so zum Beispiel mittels Laserschweißens, erfolgen. Das Fixieren erfolgt derart, dass die Aktuatorbaueinheit 63 hermetisch dicht von der Umgebung der Festkörperaktuators 7 abgedichtet ist. Die Bearbeitung wird dann in einem Schritt S15 beendet.

## Patentansprüche

1. Verfahren zum Herstellen eines Festkörperaktuators (7) mit einer Aktuatorbaueinheit (63), einer Kopfplatte (65) und einer Bodenplatte (67), bei dem
- ein Hohlzylinderteil aus Maraging-Stahl bereitgestellt wird,
- das Hohlzylinderteil auf eine vorgegebene erste Temperatur (T1) erwärmt wird, bei der der Maraging-Stahl in einem austenitischen Zustand ist,
- mittels eines Umformprozesses ein Wellrohr (69) aus dem Hohlzylinderteil geformt wird und zwar während der Maraging-Stahl in einem austenitischen Zustand ist,
- das Wellrohr (69) abgekühlt wird, derart, dass der Maraging-Stahl in einem martensitischen Zustand ist,
- die Aktuatorbaueinheit (63) in das Wellrohr (69) eingebracht wird,
- die Kopfplatte (65) und die Bodenplatte (67) derart an dem Wellrohr (69) fixiert werden, dass die Aktuatorbaueinheit (63) mit einer vorgegebenen Vorspannung zwischen der Kopfplatte (65) und der Bodenplatte (67) eingespannt ist.

2. Verfahren nach Anspruch 1,
bei dem die erste Temperatur (T1) in einem Bereich zwischen 700 und 950 °C liegt.

3. Verfahren nach einem der vorstehenden Ansprüche,
bei dem nach dem Umformprozess das Wellrohr (69) zunächst abgekühlt wird, bis eine vorgegebene Bedingung erfüllt ist und anschließend das Wellrohr (69) wieder erwärmt wird und in einem vorgegebenen Temperaturbereich für eine vorgegebene Zeitdauer (TD) gealtert wird.

4. Verfahren nach Anspruch 3,
bei dem der vorgegebene Temperaturbereich zum Altern zwischen 400 °C und 500 °C liegt.

5. Verfahren nach einem der vorstehenden Ansprüche,
bei dem der Umformprozess das Einbringen des Hohlzylinderteils in ein Formteil und ein Beaufschlagen des Hohlzylinderteils in seinem freien Innenraum mit einem vorgegebenen Gasdruck umfasst.

## Claims

1. Method for producing a solid-state actuator (7) having an actuator structural unit (63), a top plate (65) and a base plate (67), in which method
- a hollow cylindrical part composed of maraging steel is provided,
- the hollow cylindrical part is heated to a predefined first temperature (T1) at which the maraging steel is in an austenitic state,
- a corrugated tube (69) is shaped out of the hollow cylindrical part by means of a deformation process while the maraging steel is in an austenitic state,
- the corrugated tube (69) is cooled such that the maraging steel is in a martensitic state,
- the actuator structural unit (63) is inserted into the corrugated tube (69),
- the top plate (65) and the base plate (67) are fixed to the corrugated tube (69) such that the actuator structural unit (63) is braced between the top plate (65) and the base plate (67) with a predefined preload.

2. Method according to Claim 1,
in which the first temperature (T1) lies in a range between 700 and 950°C.

3. Method according to either of the preceding claims,
in which, after the deformation process, the corrugated tube (69) is firstly cooled until a predefined condition is met, and subsequently the corrugated tube (69) is heated again and age-hardened in a predefined temperature range for a predefined time duration (TD).

4. Method according to Claim 3,
in which the predefined temperature range for the age-hardening lies between 400°C and 500°C.

5. Method according to one of the preceding claims,
in which the deformation process encompasses the insertion of the hollow cylindrical part into a mold part and charging of the hollow cylindrical part, in its free interior space, with a predefined gas pressure.

## Revendications

1. Procédé de fabrication d'un actionneur à corps solide (7) avec une unité de construction d'actionneur (63), une plaque de tête (65) et une plaque de fond (67, dans lequel:
- une pièce cylindrique creuse est fabriquée en acier
maraging,
- on chauffe la pièce cylindrique creuse à une première température prédéterminée (T1), à laquelle l'acier maraging se trouve dans un état austénitique,
- par un processus de déformation, on forme un tube ondulé (69) à partir de la pièce cylindrique creuse, notamment pendant que l'acier maraging se trouve dans un état austénitique,
- on refroidit le tube ondulé (69), de telle manière que l'acier maraging se trouve dans un état martensitique,
- on introduit l'unité de construction d'actionneur (63) dans le tube ondulé (69),
- on fixe la plaque de tête (65) et la plaque de fond (67) sur le tube ondulé (69), de telle manière que l'unité de construction d'actionneur (63) soit serrée avec une précontrainte prédéterminée entre la plaque de tête (65) et la plaque de fond (67).

2. Procédé selon la revendication 1, dans lequel la première température (T1) se situe dans une plage comprise entre 700 et 950°C.

3. Procédé selon l'une quelconque des revendications précédentes, dans lequel, après le processus de déformation, on refroidit d'abord le tube ondulé (69) jusqu'à ce qu'une condition prédéterminée soit remplie et on réchauffe ensuite le tube ondulé (69) et on le vieillit dans une plage de température prédéterminée pendant une durée prédéterminée (TD).

4. Procédé selon la revendication 3, dans lequel la plage de température prédéterminée pour le vieillissement se situe entre 400°C et 500°C.

5. Procédé selon l'une quelconque des revendications précédentes, dans lequel le processus de déformation comprend l'introduction de la pièce cylindrique creuse dans une pièce moulée et une exposition de la pièce cylindrique creuse à une pression de gaz prédéterminée dans son espace intérieur libre.
